(19) Europäisches Patentamt
European Patent Office
Office européen des brevets

(11) **EP 2 539 727 B1**

(12) **FASCICULE DE BREVET EUROPEEN**

(45) Date de publication et mention de la délivrance du brevet:
**11.05.2016 Bulletin 2016/19**

(51) Int Cl.:
***G01R 33/3415*** *(2006.01)*   ***G01R 33/36*** *(2006.01)*
***G01R 33/561*** *(2006.01)*

(21) Numéro de dépôt: **11712608.6**

(86) Numéro de dépôt international:
**PCT/FR2011/050351**

(22) Date de dépôt: **18.02.2011**

(87) Numéro de publication internationale:
**WO 2011/104469 (01.09.2011 Gazette 2011/35)**

(54) **PROCEDE DE REALISATION D'UN MODULE DE PILOTAGE D'UNE ANTENNE HAUTE FREQUENCE POUR APPAREIL D'IMAGERIE PAR RESONANCE MAGNETIQUE NUCLEAIRE**

VERFAHREN ZUR ERZEUGUNG EINES MODULS ZUR STEUERUNG EINER HF-ANTENNEN FÜR EIN KERNMAGNETRESONANZBILDGEBUNGSGERÄT

METHOD FOR CREATING A MODULE FOR CONTROLLING A HIGH-FREQUENCY ANTENNA FOR A NUCLEAR MAGNETIC RESONANCE IMAGING APPARATUS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.02.2010 FR 1051301**

(43) Date de publication de la demande:
**02.01.2013 Bulletin 2013/01**

(73) Titulaire: **Commissariat à l'Énergie Atomique et aux Énergies Alternatives 75015 Paris (FR)**

(72) Inventeurs:
• **FERRAND, Guillaume**
  **F-75014 Paris (FR)**
• **LUONG, Michel**
  **F-92330 Sceaux (FR)**
• **FRANCE, Alain**
  **F-33200 Bordeaux (FR)**

(74) Mandataire: **Lebkiri, Alexandre Cabinet Camus Lebkiri 25, Rue de Maubeuge 75009 Paris (FR)**

(56) Documents cités:

• **ALAGAPPAN V ET AL: "Mode Compression of Transmit and Receive Arrrays for Parallel Imaging at 7T", INTERNATIONAL SOCIETY FOR MAGNETIC RESONANCE IN MEDICINE. SCIENTIFIC MEETING AND EXHIBITION. PROCEEDINGS, INTERNATIONAL SOCIETY FOR MAGNETIC RESONANCE IN MEDICINE, US, vol. 16, 1 janvier 2008 (2008-01-01), page 619, XP002586932, ISSN: 1524-6965**
• **ZELINSKI A C ET AL: "Sparsity-enforced coil array mode compression for parallel transmission", 16TH ANNUAL ISMRM SCIENTIFIC MEETING AND EXHIBITION 2008 : TORONTO, ONTARIO, CANADA, 3 - 9 MAY 2008, CURRAN, RED HOOK, NY, 3 mai 2008 (2008-05-03), page 1302, XP002589489, ISBN: 978-1-61567-196-0**
• **KATSCHER ET AL: "Parallel Magnetic Resonance Imaging", 20070625, vol. 4, no. 3, 25 juin 2007 (2007-06-25), pages 499-510, XP022127927,**
• **SETSOMPOP K ET AL: "Slice-selective RF pulses for in vivo B1<+> inhomogeneity mitigation at 7 Tesla using parallel RF excitation with a 16-element coil", MAGNETIC RESONANCE IN MEDICINE, ACADEMIC PRESS, DULUTH, MN, US LNKD- DOI:10.1002/MRM.21739, vol. 60, no. 6, 1 décembre 2008 (2008-12-01), pages 1422-1432, XP007915199, ISSN: 0740-3194 [extrait le 2008-11-24] cité dans la demande**

**Description**

La présente invention concerne le pilotage d'une antenne haute fréquence à voies multiples en réception et/ou en transmission, utilisées dans les appareils de Résonance Magnétique Nucléaire (RMN), ainsi que leurs applications : Imagerie par Résonance Magnétique (IRM) pour l'homme ou l'animal, Spectroscopie par Résonance Magnétique (SRM), ou encore imagerie du tenseur de diffusion.

Le domaine de l'invention est celui de la Résonance Magnétique Nucléaire (RMN) et plus particulièrement celui des antennes haute-fréquence du type réseau phasé utilisées dans les appareils d'Imagerie par Résonance Magnétique (IRM) à très haut champ magnétique, c'est-à-dire supérieur ou égal à 7 Tesla.

L'invention s'applique particulièrement au pilotage d'une antenne haute fréquence de type réseau phasé utilisée pour examiner une partie du corps humain comme par exemple la tête d'un patient.

D'une façon connue, les antennes des appareils d'IRM sont formées par des éléments rayonnants de forme variable, en cuivre ou de bande de cuivre, jouant soit le rôle de bobinages émetteurs, en résonance avec le circuit qui l'alimente, soit le rôle de récepteurs de signaux de relaxation, soit plus généralement ces deux fonctions alternativement. Elles entourent le patient ou seulement la partie du corps à analyser.

Placées dans le champ magnétique longitudinal permanent $B_O$, d'un dispositif de RMN, elles reçoivent une excitation électrique leur permettant de produire le champ magnétique radiofréquence (RF) B; orthogonal à $B_O$, à la fréquence de résonance de précession (également appelée fréquence de Larmor) des noyaux des atomes étudiés qui se trouvent dans le champ magnétique Bo, et/ou captent l'écho $B_1^-$, également onde radiofréquence à la fréquence de Larmor, produit par les atomes qui ont été momentanément soumis au champ magnétique $B_1^+$.

On rappelle que sous l'effet du champ magnétique statique $B_O$, les moments magnétiques de spin des noyaux d'atomes d'hydrogène vont progressivement s'aligner dans une direction initialement parallèle au champ magnétique $B_O$ et donner lieu à une aimantation globale dans la direction du champ $B_O$, dite direction longitudinale *z*.

Lorsqu'on applique une excitation sous forme d'impulsion, c'est-à-dire un champ magnétique oscillant à la fréquence de Larmor, noté $B_1^+$, les moments magnétiques de spin vont alors résonner et s'écarter progressivement de cet axe longitudinal z pour aller se placer perpendiculairement à leur axe de départ en décrivant un mouvement, appelé mouvement de précession. Le champ magnétique $B_1^+$ permet donc de faire « basculer » les moments magnétiques de spin pour les placer dans un plan perpendiculaire à la direction du champ $B_O$, selon un angle de bascule FA.

Lorsque l'excitation est interrompue, les moments magnétiques de spin qui se sont écartés de leur axe initial reviennent vers leur position d'équilibre, c'est-à-dire l'axe z, sans cesser de tourner. Ce retour à l'équilibre est appelé relaxation. Il est alors possible de mesurer ce mouvement de rotation des spins sous la forme d'un signal oscillant de radiofréquence qui a la même fréquence que le champ magnétique excitateur, c'est-à-dire la fréquence de résonance de Larmor. Ce signal est ensuite capté par l'antenne.

L'un des problèmes rencontrés avec de telles antennes de tête réside dans le fait qu'elles fonctionnent en champ électromagnétique proche, contrairement aux autres antennes, c'est-à-dire près des éléments physiques rayonnant.

D'une façon classique, les intensités de champ magnétique $B_O$ utilisées en imagerie médicale sont comprises entre 0,1 et 3 Tesla.

A ces faibles intensités de champ magnétique, la fréquence de fonctionnement correspondant à la fréquence de Larmor reste faible. A titre d'exemple, pour un champ magnétique $B_O$ de 1,5 Tesla, la fréquence de Larmor correspondante est de 64 MHz et pour un champ magnétique $B_O$ de 3 Tesla, la fréquence de Larmor correspondante est de 128 MHz.

Généralement, les antennes utilisées pour l'examen de la tête à faible champ (entre 0,1 et 3 Tesla) sont des antennes, dites antenne volumique, du type cage à oiseau (en anglais bird cage) ou TEM (pour Traverse Electric and Magnetic en langue anglaise) telles que décrit dans les documents US 4746866, US4751464, US 5557247. Ces antennes du type cage à oiseau sont optimisées afin de produire le plus de champ magnétique avec le moins de puissance.

Ces antennes, du type cage à oiseau, comportent au moins deux éléments rayonnants et sont alimentées par une seule voie, c'est-à-dire une seule amenée de puissance, avec un déphasage du signal de 90° au niveau de deux éléments rayonnants créant un champ magnétique tournant, l'amenée de puissance étant elle-même alimentée par un seul élément de pilotage.

Ce type d'antenne permet d'obtenir des résultats satisfaisant et notamment un champ magnétique $B_1^+$ relativement homogène sur toute la zone à étudier à des intensités de champ magnétique dites à bas et à moyen champ magnétique. En effet, avec des champs magnétiques appliqués faibles, c'est-à-dire jusqu'à 3 Tesla, la fréquence de Larmor correspondante reste faible et les artefacts sont tolérables.

Cependant, pour des intensités de champ magnétique $B_0$ importantes, c'est-à-dire supérieures ou égales à 7 Tesla, ces antennes deviennent critiques. En effet, la fréquence oscillante du champ magnétique $B_1$ devant être ajustée de façon à correspondre à la fréquence de Larmor qui est proportionnelle à l'intensité du champ magnétique statique longitudinal $B_0$ devient alors supérieure à 298 Mhz pour le noyau de proton et la longueur d'onde effective du champ magnétique $B_1$ est relativement courte, de l'ordre de quelques dizaines de centimètres, c'est-à-dire de l'ordre de la taille de l'échantillon à étudier, notamment la tête du patient.

De plus, dans cette gamme de fréquences, une grande partie de la puissance électromagnétique est perdue dans l'échantillon, et notamment à la périphérie de l'échantillon ce qui implique que les zones éloignées de la périphérie de l'échantillon reçoivent moins de puissance. Dans cette gamme de fréquence, les ondes électromagnétiques ont également une forme irrégulière créant des concentrations locales du champ magnétique au centre de l'échantillon.

Il en résulte que ces antennes, du type cage à oiseau, à ces valeurs de champs magnétiques élevées produisent des artéfacts importants et une inhomogénéité dans la répartition du champ d'excitation dans l'échantillon rendant ces antennes pratiquement inutilisables. En effet, dans les zones de l'échantillon où le champ d'excitation sera faible, le signal oscillant radiofréquence de relaxation sera faible, ce qui risque de poser des problèmes si cette zone est pertinente pour l'analyse de l'échantillon.

Il a été développé des antennes de type réseau phasé formées par la combinaison d'une pluralité d'antennes de surface, chaque antenne de surface comportant une voie propre, ou canal, d'émission et de réception du signal. Chaque antenne de surface permet ainsi de produire une image de la région anatomique en regard de laquelle elle se trouve, les différentes images sont ensuite combinées par des algorithmes pour former l'image finale.

Afin d'exploiter convenablement ces antennes de type réseau phasé, il convient que chaque canal de l'antenne soit relié à un amplificateur de puissance et que chaque amplificateur de puissance soit piloté avec une amplitude et un déphasage particulier par une interface homme/machine.

Pour cela, des procédés de pilotage ont donc été développés de façon à piloter ces antennes réseau phasé consistant notamment à utiliser des ajustements d'excitation statiques et dynamiques lors des séquences d'imagerie.

L'inconvénient de cette technologie est le coût élevé de réalisation qui est dû notamment à la multiplication des amplificateurs de puissance et surtout à celui des électroniques de pilotage nécessaires pour le pilotage de chaque canal de l'antenne. Ainsi, pour chaque canal de l'antenne, une chaîne de pilotage est attribuée.

Afin de réduire ces coûts de réalisation d'une antenne réseau, il a été développé un procédé de pilotage permettant de réduire le nombre de chaînes de pilotage générant des signaux au moyen des matrices de Butler.

Ce procédé de pilotage est mentionné notamment dans l'article « Slice-Selective RF pulses for in vivo B1 inhomogeneity mitigation at 7 Tesla using parallel RF excitation with a 16-Element coil », 2008, Kawin Setsompop.

Ce procédé de pilotage se base sur l'utilisation de la matrice de Butler qui est une matrice passive dissipant peu d'énergie ce qui permet de l'implanter entre les amplificateurs et les canaux d'antenne. Cela permet de réduire le nombre d'éléments de pilotage mais également le nombre d'amplificateurs de puissance de coût élevés. D'une façon connue, cette matrice consiste en l'excitation de certains modes de propagation électromagnétiques dans un guide d'onde cylindrique. La matrice de Butler permet de convertir des signaux, de façon à ce qu'à une entrée de puissance soit associée plusieurs sorties de même amplitude, et dont la phase varie selon le mode de propagation à exciter. Cependant, ce système est un système fixe, dont les réglages des composants passifs déphaseurs sont longs à effectuer. Ils ne permettent donc aucune modularité en fonction du nombre de canaux de l'antenne, même si différentes matrices de Butler spécifiques ont été développées pour des utilisations à 2, 4, 8, ou 16 canaux et ne sont véritablement optimales que pour des systèmes cylindriques ou des objets assimilables à des guides d'onde cylindriques. Ainsi, la matrice de Butler ne permet pas non plus de s'adapter de façon optimale aux excitations s'établissant dans une tête humaine, la tête humaine n'étant pas un guide d'onde de forme cylindrique et n'étant pas non plus homogène.

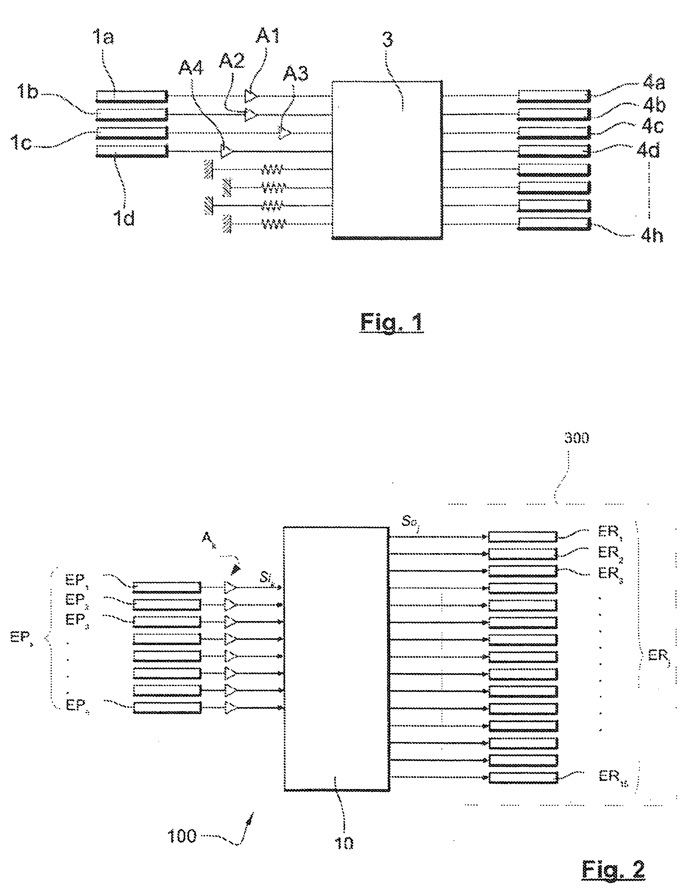

La figure 1 illustre schématiquement le principe du pilotage par matrice de Butler. Dans l'exemple illustré, quatre signaux issus d'éléments de pilotage 1a, 1 b, 1 c, 1 d sont amplifiés par des amplificateurs 2a, 2b, 2c, 2d puis convertis dans la matrice dé Butler 3 de façon à associer une entrée à deux sorties de même amplitude mais de phase différente. Ainsi, chaque canal 4a, 4b, 4c, 4d, 4e, 4f, 4g, 4h de l'antenne produit un signal d'émission de même amplitude mais avec une phase propre.

L'utilisation de la matrice de Butler pour le pilotage d'une antenne réseau phasé d'appareils d'IRM ne permet pas non plus d'obtenir une répartition du champ magnétique d'excitation $B_1^+$ suffisamment homogène à haut champ magnétique dans l'échantillon. Afin de garantir que les zones recevant le moins de puissance reçoivent tout de même assez de puissance pour générer un signal de retour, il est nécessaire d'augmenter fortement la puissance d'émission globale.

En effet, cette technique permet de sélectionner des modes d'excitation parmi les modes proposés par la matrice de Butler (et seulement parmi ceux-là) afin de réduire le nombre de degrés de liberté du système, et donc le nombre d'éléments de puissance.

Ainsi, les résultats obtenus avec ce dispositif ne permettent pas non plus d'exploiter ce type d'antenne réseau de façon optimale à très haut champ magnétique, dans la mesure où les modes d'excitation de Butler ne sont pas optimaux pour un cerveau.

Dans ce contexte, la présente invention vise à résoudre les problèmes mentionnés précédemment en proposant un procédé de réalisation d'un module de pilotage d'une antenne haute fréquence de type réseau phasé permettant d'optimiser le signal d'émission en fonction de la région d'intérêt (ROI pour Région Of Interest en langue anglaise) à analyser tout en proposant une solution économique par la réduction du nombre d'élément de pilotage nécessaires au pilotage de l'antenne.

A cette fin, l'invention propose un procédé de réalisation d'un module de pilotage d'une antenne haute fréquence pour appareil d'imagerie par résonance magnétique nucléaire tel que défini par la revendication 1, et comportant une pluralité $n$ d'éléments de pilotage et une pluralité $m$ d'éléments rayonnants, ladite pluralité $m$ d'éléments rayonnants étant supérieure à ladite pluralité $n$ d'éléments de pilotage, ledit procédé comportant successivement :

- une étape de détermination d'une cartographie de distribution d'un champ magnétique $B_1^+$ ;

- une étape de construction d'une matrice $\tilde{B}$ à partir de la sélection d'une pluralité de x points parmi ladite cartographie de $B_1^+$ déterminée lors de l'étape précédente, ladite construction de la matrice $\tilde{B}$ étant réalisée à partir de $x \times m$ points $B_{1(i.j)}^+$ avec $i$ représentant l'indice du point sélectionné variant de 1 à $x$, et $j$ représentant l'indice de l'élément rayonnant ER$_j$ variant de 1 à $m$, de sorte que $\tilde{B}_{(i.j)} = B_{1(i.j)}^+$ ;

- une étape de détermination des vecteurs singuliers de ladite matrice $\tilde{B}$ par décomposition en valeurs singulières, lesdits vecteurs singuliers de ladite matrice $\tilde{B}$ étant représentés par une matrice $(v)_{k.j}$ avec $k$ représentant l'indice d'un élément de pilotage EP$_k$ variant de 1 à $n$;

- une étape d'agencement de moyens de couplage et/ou de moyens de déphasage formant ledit module de pilotage (10) de sorte qu'un signal $So_j$ d'un élément rayonnant ER$_j$ en sortie dudit module de pilotage est fonction de la relation $So_j = \sum_{k=1}^{n} V_{k.j} \cdot Si_k$ ; avec $Si_k$ représentant le signal d'entrée d'un élément de pilotage EP$_k$.

On désigne par le terme « élément de pilotage » un sous-ensemble électronique comprenant généralement un modulateur d'amplitude et un modulateur de phase rapides qui sont contrôlés par le système informatique de l'appareil d'IRM et accessibles à l'opérateur à travers une interface homme-machine.

L'invention consiste à proposer un procédé de réalisation d'un module de pilotage permettant de piloter $m$ éléments rayonnants ER d'une antenne à voies multiples à l'aide de $n$ éléments de pilotage EP, le nombre $m$ d'éléments rayonnants ER étant supérieur au nombre $n$ d'éléments de pilotage EP. Le passage de $n$ éléments de pilotage et donc de $n$ signaux de pilotage aux $m$ signaux à l'entrée des éléments rayonnants est réalisé au moyen du module de pilotage selon l'invention.

Le module de pilotage de l'antenne réseau phasé est réalisé à partir de l'utilisation d'une méthode de décompositions en valeurs singulières permettant de définir les vecteurs singuliers de la matrice $\tilde{B}$ représentant la cartographie du champ magnétique $B_1^+$.

La méthode de décomposition en valeurs singulières (SVD pour Singular Value Decomposition en langue anglaise) d'une matrice est connue pour être un outil important de diagonalisation des matrices rectangulaires réelles et complexes. La méthode SVD est utilisée dans le domaine du traitement du signal, aux statistiques, à la météorologie et dans le domaine de la compression d'image. Mais l'utilisation de méthode de décomposition en valeurs singulière appliquée aux champs magnétiques pour l'optimisation d'un module de pilotage pilotant les signaux d'émission dans le domaine particulier de la RMN, qui est très éloigné des domaines d'utilisation classiques, est tout à fait originale.

L'utilisation de cette méthode permet en effet d'obtenir un module de pilotage avec lequel on puisse connaître exactement la puissance effectivement transmise à chaque élément rayonnant. Ainsi, lors de la conception du module, il est possible de choisir, parmi différents vecteurs singuliers, les vecteurs singuliers de plus fortes excitations, de façon à obtenir un module de pilotage qui fournit moins de puissance aux éléments rayonnants lors du pilotage de l'antenne et qui améliore le rendement d'une telle antenne réseau phasé.

De plus, ce module de pilotage obtenu par le procédé selon l'invention permet de piloter plus librement une antenne quel que soit le nombre de canaux de l'antenne, contrairement à l'utilisation d'un procédé de pilotage utilisant le principe des matrices de Butler.

Le procédé selon l'invention peut également présenter une ou plusieurs des caractéristiques définies par les revendications 2 à 8.

D'autres caractéristiques et avantages de l'invention ressortiront plus clairement de la description qui en est donnée ci-dessous, à titre indicatif et nullement limitatif, en référence aux figures annexées, parmi lesquelles :

- la figure 1 illustre un schéma d'un dispositif de pilotage d'une antenne haute fréquence, de type réseau phasé, utilisant le principe des matrices de Butler pour le pilotage de l'antenne ;
- la figure 2 illustre un schéma d'une chaîne de pilotage d'une antenne haute fréquence, de type réseau phasé ;
- la figure 3 illustre un schéma synoptique présentant les principales étapes du procédé de pilotage selon l'invention ;
- la figure 4 représente schématiquement un coupleur de type branchline utilisé lors de la quatrième étape du procédé de réalisation illustré à la figure 3 ;
- la figure 5 illustre un exemple de valeurs pour une matrice dite matrice supérieure $V_t^u$ ;
- la figure 6 illustre un exemple d'agencement de coupleurs branchline illustré à la figure 4 obtenu par le procédé de réalisation d'un module de pilotage selon l'invention.

Dans toutes les figures, les éléments communs portent les mêmes numéros de référence.

La figure 1 a déjà été décrite précédemment en référence à la présentation de l'état de la technique.

La figure 2 illustre un schéma d'une chaîne de pilotage 100 permettant le pilotage et l'alimentation d'une antenne réseau phasé 300. La chaine de pilotage 100 est formée par une pluralité $n$ d'éléments de pilotage $EP_k$, $k$ étant un indice variant de 1 à $n$, un module de pilotage 10 obtenu par le procédé de réalisation selon l'invention, relié à la pluralité $m$ de canaux ou d'éléments rayonnants $ER_j$ de l'antenne 300, $j$ étant un indice variant de 1 à $m$. La chaîne de pilotage comporte également des amplificateurs de puissance $A_k$ positionnés entre les éléments de pilotage $EP_k$ et le module de pilotage 10.

Selon l'invention, le module de pilotage 10 permet de piloter une antenne réseau phasé avec moins d'éléments de pilotage $EP$ que d'éléments rayonnants $ER$ de l'antenne (i.e. $m>n$).

A titre d'exemple, le procédé de réalisation et le module de pilotage issu du procédé seront décrits pour une antenne comportant quinze canaux indépendants d'émission et quinze éléments rayonnants ($m = 15$) pilotés par huit éléments de pilotage ($n = 8$).

On rappelle que par la désignation de canal, on entend chaque entrée de puissance de l'antenne communiquant avec un élément rayonnant.

Selon l'invention, chaque élément de pilotage $EP_k$ (i.e. $EP_1$, $EP_2$, ... $EP_n$) est formé par un sous-ensemble électronique (non représenté) comprenant généralement un modulateur d'amplitude et un modulateur de phase rapides qui sont contrôlés par le système informatique de l'appareil d'IRM et accessibles à l'opérateur à travers une interface homme/machine.

Ainsi dans notre exemple de réalisation illustré à la figure 2, le module de pilotage 10 comporte à son entrée les éléments de pilotage $EP_k$ émettant des signaux $Si_k$ (i.e $Si_1$, $Si_2$,..., $Si_8$).

Le module de pilotage 10 est relié à sa sortie à chaque élément rayonnant $ER_j$ de l'antenne qui reçoit un signal $So_j$ (i.e $So_1$, $So_2$,..., $So_{15}$).

Le module de pilotage a donc pour effet de transformer linéairement une pluralité $n$ de signaux d'entrée Si provenant de $n$ élément de pilotage en une pluralité $m$ de signaux de sortie So pour alimenter $m$ éléments rayonnants ER.

La transformation est réalisée au moyen d'une matrice $V$ de sorte que :

$$So = V\,Si$$

où :

- l'ensemble des signaux Si est représenté par une matrice de dimension $n\times1$, c'est-à-dire que le $k^{ième}$ élément de la matrice correspond au signal envoyé, dans le module de pilotage 10, par le $k^{ième}$ élément de pilotage $EP_k$, avec k variant de 1 à $n$ ;
- l'ensemble des signaux $So$ est représenté par une matrice de dimension $m\times1$, c'est-à-dire que le $j^{ième}$ élément de la matrice correspond à la puissance envoyée dans le $j^{ième}$ élément rayonnant, avec j variant de 1 à $m$ ;
- la matrice $v$ est une matrice de dimension $m\times n$ unitaire en $n$.

Ainsi dans l'exemple illustré à la figure 2, le module de pilotage 10 comporte des moyens de stockage comportant une matrice de transformation $v$ de dimension 15x8.

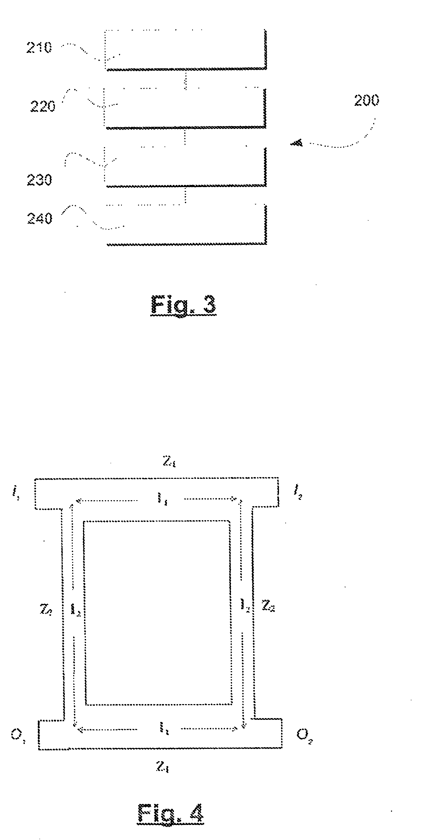

La figure 3 illustre un schéma synoptique représentant les principales étapes du procédé de réalisation du module de pilotage 10 selon l'invention.

Le procédé selon l'invention consiste dans un premier temps à déterminer les coefficients de la matrice $v$ de transformation obtenu au moyen d'une méthode dite de décomposition en valeurs singulières (SVD pour Singular Value Décomposition en langue anglaise) puis dans un second temps à construire physiquement cette matrice par un ensemble de coupleurs. La méthode de décomposition en valeurs singulières (SVD pour Singular Value Décomposition en langue anglaise) d'une matrice est généralement utilisée dans le domaine du traitement du signal, aux statistiques, à la météorologie et dans le domaine de la compression d'image. Mais l'utilisation de méthode de décomposition en valeurs singulière appliquée aux champs magnétiques pour l'optimisation d'un module de pilotage pilotant les signaux d'émission dans le domaine particulier de la RMN, qui est très éloigné des domaines d'utilisation classiques, est tout à fait originale.

Ainsi, le procédé selon l'invention comporte une première étape 210 d'établissement d'une cartographie de la distribution du champ magnétique d'excitation $B_1^+$ dans l'antenne lorsqu'une « charge » est positionnée à l'intérieur de l'antenne.

Cette cartographie de la répartition du champ magnétique est réalisée indifféremment par simulation ou par mesure sur un prototype dans un scanner IRM.

A titre d'exemple, la simulation est effectuée au moyen du logiciel de simulation numérique HFSS de la société Ansoft. Le principe de la simulation consiste à étudier systématiquement la distribution de la composante magnétique $B_1$ telle que :

$$B_1 = \begin{vmatrix} B_{1x} \\ B_{1y} \end{vmatrix}$$

les indices « x » et « y » se réfèrent à un repère cartésien fixe, lié au laboratoire, selon les axes X et Y (non représentés) perpendiculaire à l'axe longitudinal Z de l'antenne (non représenté), l'axe longitudinal $Z$ étant la direction de l'aimantation globale du champ $B_0$.

La simulation du champ magnétique $B_1$ permet de déduire $B_1^+$ au moyen d'un calcul intermédiaire, $B_1^+$ correspondant au phaseur du champ magnétique $B_1$ décomposé dans un repère tournant dans le même sens des spins selon la relation :

$$B_1^+ = \vec{B}_1 \cdot \vec{e}_{LHCP}$$

où $\vec{e}_{LHCP} = \dfrac{1}{\sqrt{2}} \begin{vmatrix} 1 \\ j \end{vmatrix}$

La détermination de la cartographie représentant- la distribution du champ magnétique $B_1^+$ peut également être réalisée expérimentalement par mesure à partir d'un prototype. Pour cela, il suffit de déterminer directement la cartographie de la composante magnétique $B_1^+$, notamment au moyen d'une méthode d'acquisition, dite méthode AFI (pour Actual Flip-angle Imaging en langue anglaise) [Vasily L. Yarnykh, Actual Flip-angle Imaging in the Pulsed Steady State. Magn Reson Led 2007 ; 57 : 192-200] connue du domaine de l'imagerie médicale.

Pour réaliser une cartographie représentant la distribution du champ magnétique par mesure, il est nécessaire que le prototype ou l'antenne de laboratoire comporte autant d'éléments de pilotage *EP* que d'élément rayonnant *ER* (i.e. *m =n* ).

Une deuxième étape 220 du procédé consiste en une étape de construction d'une matrice $\tilde{B}$ à partir de la sélection d'une pluralité de points $B_{1(i,j)}^+$ parmi la cartographie du champ magnétique complexé $B_1^+$ déterminée lors de l'étape précédente 210, la pluralité de points $B_{1(i,j)}^+$ étant sélectionnée par un maillage prédéterminé de ladite cartographie par un opérateur au moyen d'une interface homme/machine.

Le maillage de la cartographie $B_1^+$ est choisi par l'opérateur en fonction de la résolution désirée ainsi qu'en fonction de la fréquence de résonance dépendante du champ magnétique $B_0$ appliqué.

Avantageusement, un maillage de 5mm, c'est-à-dire un maillage comportant une pluralité de points dont la distance entre deux points est de 5mm, permet d'obtenir une résolution satisfaisante pour une antenne de type tête.

Au-delà d'un maillage de 5mm, les résultats risquent de perdre en précision et en deçà d'un maillage de 5mm, les éléments de calculs risquent de devenir conséquents et trop volumineux à traiter par rapport au gain de résolution apporté.

Pour cela, chaque voxel extrait de la cartographie du champ $B_1^+$, établie lors de l'étape 210 précédente, est indexé par la variable $i$ de sorte que chaque voxel correspond à un point $B_{1(i.j)}^+$

On rappelle que l'indice $j$ correspond à l'indice des éléments rayonnant $ER_j$ de l'antenne avec $j$ variant de 1 à $m$ et que l'indice $k$ correspond à l'indice des éléments de pilotage $EP_k$ avec $k$ variant de 1 à $n$.

On rappelle que le voxel est un pixel en trois dimensions utilisé par la représentation d'espace en trois dimensions notamment en imagerie médicale par traitement numérique de coupes en deux dimensions (2D) issues des appareils d'IRM.

Pour chaque voxel $i$ correspond une position $x_i$, $y_i$, $z_i$ à laquelle est associé un champ magnétique ponctuel $B_{1(i.j)}^+$ émis par un élément rayonnant $ER_j$, l'ordre d'indexation des voxels n'ayant aucune influence sur le résultat final.

Ainsi, l'élaboration de la matrice est réalisée en fonction de la cartographie réalisée dans l'étape 210 précédente de sorte que :

$$\tilde{B}_{(i.j)} = B_{1(i.j)}^+$$

La matrice $\tilde{B}$ possède autant de lignes que de voxels sélectionnés dans la région d'intérêt (ROI) dans la cartographie du champ magnétique oscillant $B_1^+$ lors de l'étape 210 d'établissement d'une cartographie de la distribution du champ magnétique d'excitation et autant de colonnes (i.e., m colonnes) que d'éléments rayonnants ER de l'antenne 300.

Typiquement, dans notre exemple illustré à la figure 2, quinze éléments rayonnants ER sont utilisés et le champ magnétique oscillant $B_1^+$ est cartographié avec une résolution en trois dimensions de 32x32x32, ce qui donne une matrice $\tilde{B}$ possédant 32768 lignes et 15 colonnes.

La troisième étape 230 du procédé est une étape de détermination des modes, c'est-à-dire des vecteurs singuliers, de la matrice $\tilde{B}$ par l'utilisation d'une méthode de décomposition en valeurs singulières, dite méthode SVD.

On rappelle qu'on entend par mode SVD les vecteurs singuliers de la décomposition en valeurs singulières. Ces modes n'ont pas de lien avec les modes électromagnétiques d'une antenne volumique ou d'une cavité résonnante.

Grâce au principe de décomposition en valeurs singulières, on associe à la matrice $\tilde{B}$ les matrices u, $\Sigma$, $v$ telles que :

$$\tilde{B}V = U\Sigma$$

avec :

$u$ matrice unitaire de même dimension que la matrice $\tilde{B}$, dont les $m$ colonnes sont unitaires (i.e. $uu^* = Im$) ;
E matrice diagonale de dimension $m \times m$ et dont les coefficients diagonaux sont des réels positifs.
$v$ matrice carré de dimension $m \times m$.

Les coefficients diagonaux de la matrice E représentent donc les valeurs singulières de la matrice $\tilde{B}$, et les colonnes de la matrice $u$ et de la matrice $v$ sont respectivement les vecteurs singuliers à gauche et à droite pour les valeurs singulières correspondantes, les vecteurs singuliers à droite de la matrice $v$ étant les modes à déterminer.

Ainsi dans notre exemple, la matrice $u$ est une matrice de dimensions 32768 x 15, et les matrices $v$ et $\Sigma$ sont des matrices de dimensions 15 x 15.

Cette décomposition est unique, à une permutation près des colonnes de $v$, de $u$ et de $\Sigma$.

Les propriétés de la matrice V et de la matrice $u$ permettent à partir de la relation :

$$\left(BV\right)^* \left(BV\right) = \left(U\Sigma\right)^* \left(U\Sigma\right),$$

d'obtenir la nouvelle relation suivante :

$$\tilde{B}^*\tilde{B} = V\Sigma^2 V^*$$

On en déduit alors que la matrice $v$ est également un vecteur propre de la matrice $\tilde{B}^*\tilde{B}$, et les valeurs propres de cette matrice $\tilde{B}^*\tilde{B}$ sont les coefficients de $\Sigma^2$.

La troisième étape 130 comporte une sous-étape de sélection de $n$ valeurs singulières de la matrice $\tilde{B}$ parmi les coefficients diagonaux de plus forte valeur de la matrice $\Sigma$.

Ainsi, on associe pour chaque mode $k$ de la matrice $\tilde{B}$ une valeur singulière $\alpha_k$ correspondant à un coefficient diagonal de la matrice $\Sigma$.

L'efficacité en puissance du $k^{ième}$ mode est alors proportionnelle à $\alpha_k^2$, c'est pourquoi la sélection des $n$ plus fortes valeurs garantie la plus grande efficacité des modes.

Ainsi pour huit éléments de pilotage $EP_1$, $EP_2$, ..., $EP_8$, les huit valeurs singulières $\alpha_1,...,\alpha_8$ de plus forte valeur parmi les quinze sont sélectionnées, $\alpha_1$ étant supérieur à $\alpha_2$ et ainsi de suite jusqu'à $\alpha_8$.

La troisième étape 130 peut comporter également une sous-étape de classement des valeurs singulières réelles par ordre croissant par permutation des vecteurs singuliers.

Chaque valeur singulière $\alpha_1,...,\alpha_8$ est associée aux vecteurs singuliers de la matrice réduite $u_8$ à $n$ colonnes ($n$ = 8), $u_8$ étant une matrice de dimension 32768 x 8. Les colonnes de la matrice réduite $u_8$ représentent la distribution du champ magnétique $B_1^+$ pour chacun des modes. A la matrice réduite $u_8$ est associée la matrice réduite $v_8$ de dimension 15 x 8 (i.e. $m \times n$) dont les colonnes représentent les modes recherchés.

Ainsi, on utilise les vecteurs singuliers, ou modes, de la matrice $\tilde{B}$, correspondant aux colonnes de la matrice $v$, pour la transformation des $n$ signaux Si des éléments de pilotage EP en $m$ signaux So alimentant les $m$ éléments rayonnants ER de l'antenne 300, de sorte qu'un élément rayonnant $ER_j$ parmi les m élément rayonnant reçoit un signal $So_j$ équivalent à :

$$So_j = \sum_{k=1}^n V_{k,j} \cdot Si_k \ ;$$

avec $j$ variant de 1 à $m$ et $k$ variant de 1 à $n$.

Ainsi, les signaux $So_j$ sont caractérisés par une amplitude proportionnelle à la somme des $|v_{k,j}|$ et dont la phase est égale à la somme des arg $(v_{k,j})$.

L'intérêt de cette décomposition est l'indépendance de chacun des modes déterminés. En effet, la construction de la matrice V assure que les modes sont orthogonaux au champ magnétique excitateur $B_1^+$.

La matrice $v$ étant une matrice unitaire, telle que $vv^* = I_{15}$, elle permet de garantir que la puissance de sortie du module de pilotage 10 est équivalente à la puissance d'entrée selon la démonstration suivante :

$$\|S_o\|_2^2 = S_o^* S_o = (VS_i)^* VS_i = S_i^* V^* V S_i = S_i^* S_i = \|S_i\|_2^2$$

Ainsi, la transformation est réalisée sans perte d'énergie.

Cette décomposition est également avantageuse dans la mesure où le choix des modes selon la troisième étape 230 se fait en fonction de leurs rendements énergétiques. En effet, comme décrit précédemment, les valeurs singulières de la matrice $\tilde{B}$, c'est-à-dire les coefficients diagonaux de la matrice $\Sigma$ sont proportionnelles à

$\sqrt{\iiint_{tête} |B_1^+|^2 \, dV}$ pour-chaque mode étudié.

On en déduit alors pour une puissance d'entrée arbitraire le rendement énergétique de la charge introduite dans l'antenne, dans notre cas la tête du patient, selon la relation :

$$E_m^+ = \iiint_{tête} \frac{1}{2}\mu |B_1^+|^2 \, dV$$

Les champs $B_1^+$ étant orthogonaux pour chaque mode, l'énergie magnétique excitatrice totale reçue, par le patient dans la zone ROI, est égale à la somme des énergies excitatrices de chaque mode, si plusieurs modes sont excités.

Ce calcul de rendement énergétique peut être réalisé aussi bien à partir d'une cartographie de distribution de $B_1^+$ obtenue par simulation ou par mesure, puisque seuls les éléments nécessaires à ce calcul sont les valeurs de $B_1^+$ et la différence de phase d'un élément rayonnant ER à un autre.

La quatrième étape 240 consiste en une étape de d'agencement de moyens de couplage et de moyens de déphasage de façon à reproduire la transformation de signaux de la matrice $v$ déterminée lors de l'étape précédente 230.

On rappelle que la matrice $v$ obtenu est une matrice unitaire en $n$, c'est-à-dire que la matrice $v$ vérifie la relation : $v^*v = I_n$, où $I_n$ est la matrice identité de dimension $n \times n$.

Ainsi, en introduisant des sorties intermédiaires $So_{j,l}$ de rang $l$ avec $l$ variant de 0 à N et des matrices unitaires intermédiaires $v_l$ ($l>0$) de dimension $m \times m$ et $v_0$ ($l=0$) de dimension $m \times n$ telles que :

$$So_{j,0} = Si \text{ pour } l = 0$$

$$So_{j,l} = V_l So_{j,l-1} \text{ pour } N \geq l > 0$$

$$So_{j,N} = So_j$$

Si les matrices intermédiaires $v_l$ sont unitaires, on obtient alors $v_N \times v_{N-1} \times ... \times v_1 \times v_0$ qui est unitaire de dimension $m \times n$.

Ce principe de décomposition en une pluralité de matrice est utilisé pour la construction de la matrice V de sorte que :

$$So = V Si = V_N \times V_{N-1} \times ... \times V_1 \times V_0 Si$$

Ensuite chaque matrice $v_0, v_1..., v_N$ est réalisée au moyen de coupleurs de type coupleurs branchline tels qu'illustré à la figure 4.

Les coupleurs dits branchline sont des coupleurs directionnels, généralement utilisés par une répartition à 3 décibels de l'énergie.

D'une façon générale, le coupleur branchline comporte deux entrées et deux sorties et permet donc de transformer les entrées $\begin{bmatrix} I_1 \\ I_2 \end{bmatrix}$ sortie $\begin{bmatrix} O_1 \\ O_2 \end{bmatrix}$ selon la relation :

$$\begin{bmatrix} O_1 \\ O_2 \end{bmatrix} = -\begin{bmatrix} j\cos\theta & \sin\theta \\ \sin\theta & j\cos\theta \end{bmatrix}\begin{bmatrix} I_1 \\ I_2 \end{bmatrix}$$

où $\theta$ peut être choisi arbitrairement.

Il est également possible d'associer au coupleur branchline un déphasage à partir d'une ligne de transmission provoquant un retard de l'onde. Ce déphasage peut être représenté par la matrice unitaire :

$$\begin{bmatrix} e^{j\phi_1} & 0 \\ 0 & e^{j\phi_2} \end{bmatrix}$$

Le produit est donc une matrice unitaire :

$$C\left(\theta,\phi_1,\phi_2\right) = \begin{bmatrix} e^{j\phi_1} j\cos\theta & e^{j\phi_1}\sin\theta \\ e^{j\phi_2}\sin\theta & e^{j\phi_2} j\cos\theta \end{bmatrix}$$

La première matrice $v_0$ doit être de dimension $m \times n$, soit dans notre exemple de réalisation illustré à la figure 2 de dimension 15 x 8.

Pour obtenir 15 sorties à partir de 8 entrées avec des coupleurs branchline tels que décrit précédemment, il suffit d'utiliser 7 coupleurs branchline dont chaque coupleur comporte une entrée chargée avec une résistance, par exemple de 50 Ω. Dans ce cas, la matrice de transformation de chaque coupleur branchline devient pour une entrée $I$ :

$$\begin{bmatrix} O_1 \\ O_2 \end{bmatrix} = -\begin{bmatrix} j\cos\theta \\ \sin\theta \end{bmatrix}[I] = -\begin{bmatrix} j\cos\theta \cdot I \\ \sin\theta \cdot I \end{bmatrix}$$

Ainsi, en connectant un coupleur branchline ainsi conçu à 7 des 8 entrées, on obtient 15 sorties, la huitième entrée étant connectée directement à une sortie dans l'utilisation d'un coupleur. En connectant ainsi, la première entrée à la première et à la neuvième sortie, la deuxième entrée à la deuxième et dixième sortie ainsi de suite et la huitième entrée directement à la huitième sortie, on obtient la première matrice $v_0$ :

$$V_0\left(\theta_1,...,\theta_7\right) = \begin{bmatrix}
j\cos\theta_1 & 0 & 0 & 0 & 0 & 0 & 0 & 0 \\
0 & j\cos\theta_2 & 0 & 0 & 0 & 0 & 0 & 0 \\
0 & 0 & j\cos\theta_3 & 0 & 0 & 0 & 0 & 0 \\
0 & 0 & 0 & j\cos\theta_4 & 0 & 0 & 0 & 0 \\
0 & 0 & 0 & 0 & j\cos\theta_5 & 0 & 0 & 0 \\
0 & 0 & 0 & 0 & 0 & j\cos\theta_6 & 0 & 0 \\
0 & 0 & 0 & 0 & 0 & 0 & j\cos\theta_7 & 0 \\
0 & 0 & 0 & 0 & 0 & 0 & 0 & 1 \\
\sin\theta_1 & 0 & 0 & 0 & 0 & 0 & 0 & 0 \\
0 & \sin\theta_2 & 0 & 0 & 0 & 0 & 0 & 0 \\
0 & 0 & \sin\theta_3 & 0 & 0 & 0 & 0 & 0 \\
0 & 0 & 0 & \sin\theta_4 & 0 & 0 & 0 & 0 \\
0 & 0 & 0 & 0 & \sin\theta_5 & 0 & 0 & 0 \\
0 & 0 & 0 & 0 & 0 & \sin\theta_6 & 0 & 0 \\
0 & 0 & 0 & 0 & 0 & 0 & \sin\theta_7 & 0
\end{bmatrix}$$

Les matrices $v_1,...,v_{N-1},v_N$ sont réalisées également au moyen de coupleurs dits coupleurs branchline. Pour la réalisation de ces matrices, les coupleurs ne comportent pas de charge à leur entrée mais créent un déphasage θ en sortie.

Chacune des matrices $v_1,...,v_{N-1},v_N$ peut être réalisée par l'alternance de deux matrices que l'on nommera matrice supérieure $V_l^u$ et matrice inférieure $V_l^d$, $l$ variant de 1 à N.

La matrice supérieure $V_l^u$ est construite de sorte qu'un coupleur connecte la première entrée et la deuxième entrée, la troisième entrée et la quatrième entrée et ainsi de suite jusqu'à qu'à la treizième entrée et la quatorzième entrée et laisse la quinzième entrée inchangée.

La matrice inférieure $V_l^d$ est construite de sorte qu'un coupleur connecte la deuxième entrée et la troisième entrée, la quatrième entrée et la cinquième entrée, etc. jusqu'à qu'à la quatorzième entrée et la quinzième entrée et laisse la première entrée inchangée.

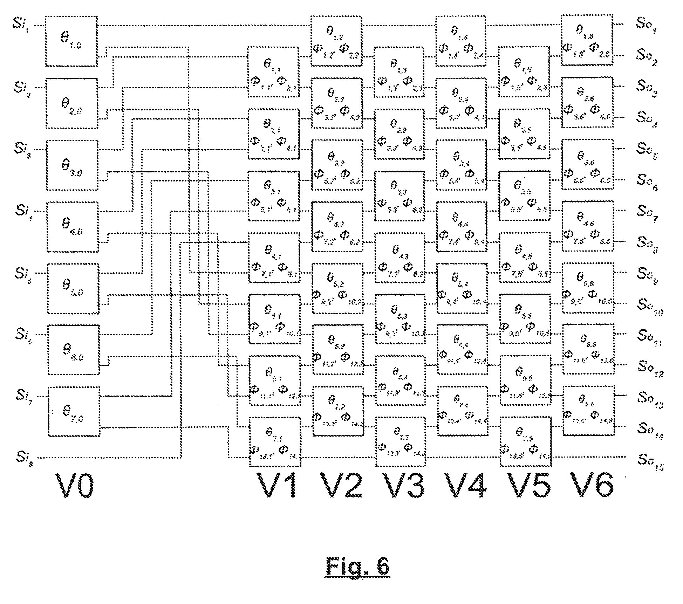

Cette configuration permet d'éviter de croiser les coupleurs et facilite la conception de la matrice *v* du module de pilotage 10. Une telle conception est illustrée à titre d'exemple à la figure 6.

Ainsi, dans le cas où le nombre *m* d'éléments rayonnants ER est pair alors la matrice supérieure $V_t^u$ applique une transformation sur toutes les entrées couplant les paires 1-2, 3-4, etc. ; et la matrice inférieure $V_t^d$ n'appliquera pas de transformation sur la première et la dernière entrée, les coupleurs reliant les paires 2-3, 4-5, etc.

Au final, le placement des coupleurs permet d'obtenir une matrice $v_1,...,v_{N-1},v_N$ dont chacune dépend de 7 paramètres θ de couplage et quinze paramètres Φ de déphasage.

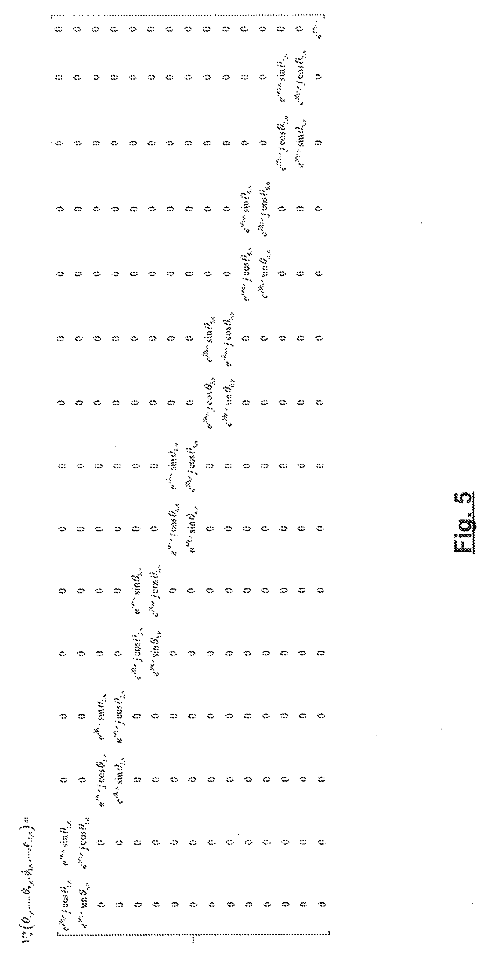

Un exemple de valeurs pour la réalisation de la matrice supérieure $V_t^u$ est illustré en référence à la figure 5.

Ainsi, les matrices $v_0, v_1,..., v_N$ sont définies et permettent la fabrication de la matrice *v* en vérifiant les hypothèses précédentes.

Pour chacune des matrices $v_0, v_1,..., v_N$, il est toutefois nécessaire de déterminer les valeurs de θ et de Φ permettant d'obtenir la matrice *v* désirée, c'est-à-dire la matrice *v* déterminée lors des étapes précédentes.

Selon un mode avantageux de l'invention, la matrice *v* est approximée par une matrice approchée $v_{amp}$ permettant ainsi de limiter les coûts de réalisation de cette matrice. Ainsi, la matrice approchée $v_{app}$ possède les mêmes propriétés de matrice unitaire que la matrice *v* mais les valeurs sont approchées à une erreur ε près de sorte que :

$$\left\| V_{app} - V \right\|_2 < \varepsilon$$

Ainsi, la détermination des valeurs de θ et de Φ est réalisée par optimisation de sorte que :

$$\Delta_{SVD}\left(\theta_{1,0},...,\theta_{7,N},\phi_{1,0},...,\phi_{15,N}\right) = V_N\left(\theta_{1,N},...,\theta_{7,N},\phi_{1,N}...\phi_{15,N}\right) \times...\times V_0\left(\theta_{1,0},...,\theta_{7,0},\phi_{1,0}...\phi_{15,0}\right) - V$$

où :

- $\theta_{i,j}$ est le $i^{ème}$ élément de couplage *de* $v_j$ ; *i* variant de 1 à 7 selon notre exemple de réalisation ;
- $\Phi_{i,j}$ est le $i^{ème}$ élément de déphasage de $V_j$ ; *i* variant de 1 à 15 selon notre exemple de réalisation ; et avec $\left\|\Delta_{SVD}\right\| = \varepsilon$.

Cette optimisation montre que N=12 est généralement suffisant pour 15 éléments rayonnants avec une erreur inférieure à 5% par canal.

Ainsi selon notre mode de réalisation, la construction de la matrice *v* nécessite alors 91 coupleurs et 195 éléments de déphasage.

Les 286 paramètres réels devront être optimisés par des algorithmes d'optimisation, comme par exemple par les algorithmes d'optimisation de logiciel de type MatLab.

L'invention a été particulièrement décrite pour le pilotage d'une antenne haute fréquence d'IRM pour l'examen de la tête ; toutefois, le procédé de pilotage et notamment la méthode SVD décrite est également applicable pour n'importe quelle partie du corps et n'importe quel patient, enfant, adulte, ou encore une personne de forte corpulence, etc.

Les champs magnétiques $B_1$ mesurés ou simulés dépendent évidemment de la partie du corps, ou de l'objet, introduit dans l'antenne. Les résultats du calcul varient en fonction de la partie du corps introduite mais également en fonction du patient.

Le procédé selon l'invention utilisant une méthode de décomposition en valeurs singulières permet de faciliter l'optimisation du résultat de l'ajustement de l'excitation statique et dynamique et notamment la qualité de l'ajustement des signaux par des algorithmes d'optimisation du type Gauss Newton ou encore de tout type d'algorithme requérant une valeur initiale pour l'optimisation.

Dans ce cas, l'optimisation peut être réalisée dans un premier temps pour le premier mode, puis progressivement pour les modes suivants.

## Revendications

1. Procédé de réalisation d'un module de pilotage (10) d'une antenne haute fréquence (300) pour appareil d'imagerie par résonance magnétique comportant une pluralité *n* d'éléments de pilotage (EP$_1$, EP$_2$,..., EP$_n$) et une pluralité *m*

d'éléments rayonnants ($ER_1$, $ER_2$,..., $ER_m$), ladite pluralité *m* d'éléments rayonnants étant supérieure à ladite pluralité *n* d'éléments de pilotage ($EP_1$, $EP_2$, ...$EP_n$), ledit procédé comportant successivement :

- une étape (210) de détermination d'une cartographie de distribution d'un champ magnétique $B_1^+$ ;

- une étape (220) de construction d'une matrice $\tilde{B}$ à partir de la sélection d'une pluralité de x points parmi ladite cartographie de $B_1^+$ déterminée lors de l'étape précédente, ladite construction de la matrice $\tilde{B}$ étant réalisée à partir de $x \times m$ points $B_{1(i,j)}^+$ avec *i* représentant l'indice du point sélectionné variant de 1 à x, et *j* représentant l'indice de l'élément rayonnant $ER_j$ variant de 1 à *m,* de sorte que $\tilde{B}_{(i,j)} = B_{1(i,j)}^+$ ;

- une étape (230) de détermination des vecteurs singuliers de ladite matrice $\tilde{B}$ par décomposition en valeurs singulières, lesdits vecteurs singuliers de ladite matrice $\tilde{B}$ étant représentés par une matrice $(v)_{k,j}$ avec *k* représentant l'indice d'un élément de pilotage $EP_k$ variant de 1 à *n* ;

- une étape (240) d'agencement de moyens de couplage et/ou de moyens de déphasage formant ledit module de pilotage (10) de sorte qu'un signal $So_j$ d'un élément rayonnant $ER_j$ en sortie dudit module de pilotage est fonction de la relation :

$$So_j = \sum_{k=1}^{n} V_{k,j} \cdot Si_k$$

avec *Sik* représentant le signal d'entrée d'un élément de pilotage $EP_k$.

2. Procédé de réalisation d'un module de pilotage (10) d'une antenne haute fréquence (300) pour appareil d'imagerie par résonance magnétique selon la revendication 1 **caractérisé en ce que** ladite étape (240) d'agencement de moyens de couplage et/ou de moyens de déphasage formant ledit module de pilotage (10) est réalisée au moyens de coupleurs, dits coupleur branchline, agissant en tant que moyens de couplage et/ou moyens de déphasage.

3. Procédé de réalisation d'un module de pilotage (10) d'une antenne haute fréquence (300) pour appareil d'imagerie par résonance magnétique selon l'une des revendications 1 à 2 **caractérisé en ce qu'**il comporte une étape de décomposition de ladite matrice *v* en une pluralité N+1 de matrice selon la relation :

$$V = V_N \times V_{N-1} \times ... \times V_1 \times V_0$$

4. Procédé de réalisation d'un module de pilotage (10) d'une antenne haute fréquence (300) pour appareil d'imagerie par résonance magnétique selon l'une des revendications 1 à 3 **caractérisé en ce que** ladite décomposition en valeurs singulières de l'étape (230) de détermination des vecteurs singuliers de ladite matrice $\tilde{B}$ est réalisée au moyen de la relation :

$$\tilde{B}V = U\Sigma$$

avec :

*u* matrice unitaire de même dimension que la matrice $\tilde{B}$, et dont les m colonnes sont unitaires ;
$\Sigma$ matrice diagonale de dimension $m \times m$ et dont les coefficients diagonaux sont des réels positifs.

5. Procédé de réalisation d'un module de pilotage (10) d'une antenne haute fréquence (300) pour appareil d'imagerie par résonance magnétique selon la revendication 4 **caractérisé en ce que** ladite l'étape (230) de détermination des vecteurs singuliers de ladite matrice $\tilde{B}$ est réalisée au moyen de la relation :

$$\tilde{B}^* \tilde{B} = V\Sigma^2 V^* .$$

6. Procédé de réalisation d'un module de pilotage (10) d'une antenne haute fréquence (300) pour appareil d'imagerie par résonance magnétique selon l'une des revendications 1 à 5 **caractérisé en ce que** ladite étape (230) de détermination des vecteurs singuliers de ladite matrice $\tilde{B}$ comporte une sous-étape de sélection de $n$ valeurs singulières de plus forte valeur représentées par les coefficients diagonaux de la matrice $\Sigma$.

7. Procédé de réalisation d'un module de pilotage (10) d'une antenne haute fréquence (300) pour appareil d'imagerie par résonance magnétique selon l'une des revendications 1 à 6 **caractérisé en ce que** ladite étape (210) de détermination d'une cartographie de distribution d'un champ magnétique $B_1^+$ est réalisée par simulation d'un champ électromagnétique $B_1$ via des moyens logiciels.

8. Procédé de réalisation d'un module de pilotage (10) d'une antenne haute fréquence (300) pour appareil d'imagerie par résonance magnétique selon l'une des revendications 1 à 7 **caractérisé en ce que** ladite étape (210) de détermination d'une cartographie de distribution d'un champ magnétique $B_1^+$ est réalisée par mesure au moyen d'une antenne de laboratoire comportant autant d'éléments de pilotage que d'éléments rayonnants.


**Patentansprüche**

1. Realisierungsverfahren eines Steuerungsmoduls (10) einer Hochfrequenzantenne (300) für ein Gerät zur Magnetresonanzbilderzeugung, umfassend eine Vielzahl $n$ von Steuerelementen ($EP_1$, $EP_2$, ..., $EP_n$) und eine Vielzahl $m$ von strahlenden Elementen ($ER_1$, $ER_2$, ..., $ER_m$), wobei die genannte Vielzahl $m$ von strahlenden Elementen größer ist als die genannte Vielzahl $n$ von Steuerelementen ($EP_1$, $EP_2$, ... $EP_n$), wobei das genannte Verfahren sukzessive umfasst:

    - eine Stufe (210) zur Bestimmung einer Verteilerkartographie eines Magnetfeldes $B_1^+$;

    - eine Stufe (220) zum Aufbau einer Matrix B ausgehend von der Auswahl einer Vielzahl von $x$ Punkten aus der genannten Kartographie von $B_1^+$, die in der voranstehenden Stufe bestimmt wird, wobei der genannte Aufbau der Matrix $B$ ausgehend von $x \times m$ Punkten $B_{1(i,j)}^+$ realisiert wird, wobei $i$ den Index des ausgewählten Punktes darstellt, der von 1 bis $x$ variiert, und $j$ den Index des strahlenden Elements $ER_j$ darstellt, das von 1 bis $m$ derart variiert, dass $\tilde{B}_{(i,j)} = B_{1(i,j)}^+$;

    - eine Stufe (230) zur Bestimmung der einzigartigen Vektoren der genannten Matrix $\tilde{B}$ per Zerlegung in einzigartige Werte, wobei die genannten einzigartigen Werte der genannten Matrix $\tilde{B}$ durch eine Matrix $(v)_{k,j}$ dargestellt werden, wobei $k$ den Index eines Steuerelements $EP_k$ darstellt, das von 1 bis $n$ variiert;
    - eine Stufe (240) zur Anordnung von Kopplungsmitteln und / oder Phasenverschiebungsmitteln, die das genannte Steuermodul (10) derart bilden, dass ein Signal $So_j$ eines strahlenden Elements $ER_j$ am Ausgang des genannten Steuermoduls von dem Verhältnis abhängt:

$$So_j = \sum_{k=1}^{n} V_{k,j} \cdot Si_k$$

    wobei $Si_k$ das Eingangssignal eines Steuerelements $EP_k$ darstellt.

2. Realisierungsverfahren eines Steuermoduls (10) einer Hochfrequenzantenne (300) für ein Gerät zur Magnetresonanzbilderzeugung gemäß Anspruch 1, **dadurch gekennzeichnet, dass** die genannte Stufe (240) zur Anordnung von Kopplungsmitteln und / oder Phasenverschiebungsmitteln, die das genannte Steuermodul (10) bildet, mittels Kopplern, bezeichnet als Branchline-Koppler, realisiert ist, die als Kopplungsmittel und / oder Phasenverschiebungsmittel wirken.

3. Realisierungsverfahren eines Steuermoduls (10) einer Hochfrequenzantenne (300) für ein Gerät zur Magnetresonanzbilderzeugung gemäß Anspruch 1 bis 2, **dadurch gekennzeichnet, dass** es eine Stufe zur Zerlegung der genannten Matrix V in eine Vielzahl von N+1 der Matrix gemäß dem Verhältnis:

$$V = V_N \times V_{N-1} \times ... \times V_1 \times V_0$$

4. Realisierungsverfahren eines Steuermoduls (10) einer Hochfrequenzantenne (300) für ein Gerät zur Magnetresonanzbilderzeugung gemäß Anspruch 1 bis 3, **dadurch gekennzeichnet, dass** die genannte Zerlegung in einzigartige Werte der Stufe (230) zur Bestimmung der einzigartigen Vektoren der genannten Matrix $\tilde{B}$ mittel des Verhältnisses :

$$\tilde{B}V = U\Sigma$$

realisiert wird, wobei:

    $u$ die Einheitsmatrix mit denselben Abmessungen wie die Matrix $\tilde{B}$ ist und deren $m$ Säulen einheitlich sind;
    $\sum$ die diagonale Matrix mit den Abmessungen $m \times m$ ist und deren diagonale Koeffizienten positive reelle Zahlen sind.

5. Realisierungsverfahren eines Steuermoduls (10) einer Hochfrequenzantenne (300) für ein Gerät zur Magnetresonanzbilderzeugung gemäß Anspruch 4, **dadurch gekennzeichnet, dass** die genannte Stufe (230) zur Bestimmung der einzigartigen Vektoren der genannten Matrix $\tilde{B}$ mittels des Verhältnisses realisiert wird :

$$\tilde{B}^* \tilde{B} = V\Sigma^2 V^*$$

6. Realisierungsverfahren eines Steuermoduls (10) einer Hochfrequenzantenne (300) für ein Gerät zur Magnetresonanzbilderzeugung gemäß Anspruch 1 bis 5, **dadurch gekennzeichnet, dass** die genannte Stufe (230) zur Bestimmung der einzigartigen Vektoren der genannten Matrix $\tilde{B}$ eine Unterstufe zur Auswahl von $n$ einzigartigen Werten mit einem höheren Wert umfasst, die durch die diagonalen Koeffizienten der Matrix $\sum$ dargestellt werden.

7. Realisierungsverfahren eines Steuermoduls (10) einer Hochfrequenzantenne (300) für ein Gerät zur Magnetresonanzbilderzeugung gemäß Anspruch 1 bis 6, **dadurch gekennzeichnet, dass** die genannte Stufe (210) zur Bestimmung einer Verteilerkartographie eines Magnetfeldes $B^+_1$ per Simulation eines elektromagnetischen Feldes $B_1$ über Softwaremittel realisiert wird.

8. Realisierungsverfahren eines Steuermoduls (10) einer Hochfrequenzantenne (300) für ein Gerät zur Magnetresonanzbilderzeugung gemäß Anspruch 1 bis 7, **dadurch gekennzeichnet, dass** die genannte Stufe (210) zur Bestimmung einer Verteilerkartographie eines Magnetfeldes $B^+_1$ per Messung mittels einer Laborantenne realisiert wird, die ebenso viele Steuerelemente wie strahlende Elemente umfasst.

**Claims**

1. Method for creating a control module (10) for a high-frequency antenna (300) for a nuclear magnetic resonance imaging device comprising a plurality $n$ of control elements ($EP_1$, $EP_2$, ..., $EP_n$) and a plurality $m$ of radiating elements ($ER_1$, $ER_2$,..., $ER_m$), said plurality $m$ of radiating elements being greater than said plurality $n$ of control elements ($EP_1$, $EP_2$, ..., $EP_n$), said method comprising successively:

    - a step (210) of determining a distribution map of a magnetic field $B^+_1$ ;

    - a step (220) of constructing a matrix $\tilde{B}$ on the basis of the selection of a plurality of $x$ points from said map of $B^+_1$ determined in the previous step, said construction of matrix $\tilde{B}$ being carried out using $x \times m$ $B^+_{1(i,j)}$ where $i$ represents the index of the selected point that varies from 1 to x and $j$ represents the index of radiating element $ER_j$ that varies from 1 to $m$, such that $\tilde{B}_{(i,j)} = B^+_{1(i,j)}$ ; =

    - a step (230) of determining singular vectors of said matrix $\tilde{B}$ by singular value decomposition, said singular vectors of said matrix $B$ being represented by a matrix $(v)_{k,j}$ where $k$ represents the index of a control element

$EP_k$ that varies from 1 to $n$ ;;
- a step (240) of arranging coupling means and/or phase shifting means to form said control module (10) such that a signal $So_j$ of a radiating element $ER_j$ at the output of said control module is a function of relation:

$$So_j = \sum_{k=1}^{n} V_{k,j} \cdot Si_k$$

with $Si_k$ represents the input signal of a control element $EP_k$

2. Method for creating a control module (10) for a high-frequency antenna (300) for a nuclear magnetic resonance imaging device according to claim 1 **characterised in that** said step (240) arranging coupling means and/or phase shifting means to form said control module (10) is carried out using couplers, referred to as branchline couplers, acting as a coupling means and/or phase shifting means.

3. Method for creating a control module (10) for a high-frequency antenna (300) for a nuclear magnetic resonance imaging device according to one of claims 1 to 2 **characterised in that** it comprises a step of decomposing said matrix V into a plurality N+1 of matrix according to the relation:

$$V = V_N \times V_{N-1} \times ... \times V_1 \times V_0$$

4. Method for creating a control module (10) for a high-frequency antenna (300) for a nuclear magnetic resonance imaging device according to one of claims 1 to 3 **characterised in that** said singular value decomposition of the step (230) of determining singular vectors of said matrix $B$ is carried out using the relation:

$$\tilde{B}V = u\Sigma$$

with:

$u$ unitary matrix having the same dimensions as the *matrix B,* and in which the $m$ columns are unitary;
$\Sigma$ diagonal matrix having dimensions $m \times m$ and in which the diagonal coefficients are positive real numbers.

5. Method for creating a control module (10) for a high-frequency antenna (300) for a nuclear magnetic resonance imaging device according to claim 4 **characterised in that** said step (230) of determining singular vectors of said matrix $B$ is carried out using the relation:

$$\tilde{B}^* \tilde{B} = V\Sigma^2 V^*$$

6. Method for creating a control module (10) for a high-frequency antenna (300) for a nuclear magnetic resonance imaging device according to one of claims 1 to 5 **characterised in that** said step (230) of determining singular vectors of said *matrix $\tilde{B}$* comprises a substep of selecting $n$ singular values that have higher values as represented by the diagonal coefficients of the matrix $\Sigma$.

7. Method for creating a control module (10) for a high-frequency antenna (300) for a nuclear magnetic resonance imaging device according to one of claims 1 to 6 **characterised in that** said step (210) of determining a distribution map of a magnetic field $B_1^+$ is carried out by simulation of an electromagnetic field $B_1$ via means of software.

8. Method for creating a control module (10) for a high-frequency antenna (300) for a nuclear magnetic resonance imaging device according to one of claims 1 to 7 **characterised in that** said step (210) of determining a distribution map of a magnetic field $B_1^+$ is carried out by measurement using a laboratory antenna that comprises as many control elements as radiating elements.

Fig. 1

Fig. 2

**Fig. 3**

**Fig. 4**

$$V_v^*(\theta_{v,1}\cdots\theta_{v,k},\theta_{v,k}\cdots\theta_{v,v}) =$$

$$\begin{bmatrix}
e^{j\phi}j\cos\theta_{1,2} & e^{j\phi}\sin\theta_{1,2} & 0 & 0 & 0 & 0 & 0 & 0 & 0 & 0 & 0 & 0 & 0 & 0 & 0 \\
e^{j\phi}\sin\theta_{1,2} & e^{j\phi}j\cos\theta_{1,2} & 0 & 0 & 0 & 0 & 0 & 0 & 0 & 0 & 0 & 0 & 0 & 0 & 0 \\
0 & 0 & e^{j\phi}j\cos\theta_{2,3} & e^{j\phi}\sin\theta_{2,3} & 0 & 0 & 0 & 0 & 0 & 0 & 0 & 0 & 0 & 0 & 0 \\
0 & 0 & e^{j\phi}\sin\theta_{2,3} & e^{j\phi}j\cos\theta_{2,3} & 0 & 0 & 0 & 0 & 0 & 0 & 0 & 0 & 0 & 0 & 0 \\
0 & 0 & 0 & 0 & e^{j\phi}j\cos\theta_{3,4} & e^{j\phi}\sin\theta_{3,4} & 0 & 0 & 0 & 0 & 0 & 0 & 0 & 0 & 0 \\
0 & 0 & 0 & 0 & e^{j\phi}\sin\theta_{3,4} & e^{j\phi}j\cos\theta_{3,4} & 0 & 0 & 0 & 0 & 0 & 0 & 0 & 0 & 0 \\
0 & 0 & 0 & 0 & 0 & 0 & e^{j\phi}j\cos\theta_{4,5} & e^{j\phi}\sin\theta_{4,5} & 0 & 0 & 0 & 0 & 0 & 0 & 0 \\
0 & 0 & 0 & 0 & 0 & 0 & e^{j\phi}\sin\theta_{4,5} & e^{j\phi}j\cos\theta_{4,5} & 0 & 0 & 0 & 0 & 0 & 0 & 0 \\
0 & 0 & 0 & 0 & 0 & 0 & 0 & 0 & e^{j\phi}j\cos\theta_{5,6} & e^{j\phi}\sin\theta_{5,6} & 0 & 0 & 0 & 0 & 0 \\
0 & 0 & 0 & 0 & 0 & 0 & 0 & 0 & e^{j\phi}\sin\theta_{5,6} & e^{j\phi}j\cos\theta_{5,6} & 0 & 0 & 0 & 0 & 0 \\
0 & 0 & 0 & 0 & 0 & 0 & 0 & 0 & 0 & 0 & e^{j\phi}j\cos\theta_{6,7} & e^{j\phi}\sin\theta_{6,7} & 0 & 0 & 0 \\
0 & 0 & 0 & 0 & 0 & 0 & 0 & 0 & 0 & 0 & e^{j\phi}\sin\theta_{6,7} & e^{j\phi}j\cos\theta_{6,7} & 0 & 0 & 0 \\
0 & 0 & 0 & 0 & 0 & 0 & 0 & 0 & 0 & 0 & 0 & 0 & e^{j\phi}j\cos\theta_{7,8} & e^{j\phi}\sin\theta_{7,8} & 0 \\
0 & 0 & 0 & 0 & 0 & 0 & 0 & 0 & 0 & 0 & 0 & 0 & e^{j\phi}\sin\theta_{7,8} & e^{j\phi}j\cos\theta_{7,8} & 0 \\
0 & 0 & 0 & 0 & 0 & 0 & 0 & 0 & 0 & 0 & 0 & 0 & 0 & 0 & e^{j\phi}
\end{bmatrix}$$

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4746866 A
- US 4751464 A

- US 5557247 A

**Littérature non-brevet citée dans la description**

- **VASILY L. YARNYKH.** Actual Flip-angle Imaging in the Pulsed Steady State. *Magn Reson Led,* 2007, vol. 57, 192-200